# EUROPEAN PATENT APPLICATION

(11) **EP 1 764 918 A1**
(43) Date of publication of application: **21.03.2007**
(21) Application number: 05736982.9
(22) Date of filing: 28.04.2005
(51) Int. Cl.: H03H 9/54, H01P 5/10, H01P 5/19, H01P 5/22, H03H 7/42, H03H 9/17

(54) **FBAR FILTER**

(30) Priority: 17.06.2004 JP 2004179262; 17.06.2004 JP 2004179263
(71) Applicant: MATSUSHITA ELECTRIC INDUSTRIAL CO., LTD., Kadoma-shi, Osaka 571-8501 (JP)
(72) Inventor: YAHATA, K. c/o Matsushita Electric Ind. Co., Ltd., Shiromi Chuo-ku Osaka-shi Osaka 540-6319 (JP); TANAKA, T. c/o Matsushita Electric Ind. Co., Ltd., Shiromi Chuo-ku Osaka-shi Osaka 540-6319 (JP); ISHII, M. c/o Matsushita Electric Ind. Co., Ltd., Shiromi Chuo-ku Osaka-shi Osaka 540-6319 (JP)
(74) Representative: Pautex Schneider, Nicole Véronique
(86) International application number: PCT/JP2005/008187
(87) International publication number: WO 2005/125008

(57) **Abstract**

[Problem]

Providing an FBAR filter added with a balance-unbalance conversion function.

[Solution]

The FBAR filter includes: an FBAR filter device 108 having two unbalanced terminals 101 and 104, and which performs filtering of a signal between such terminals; and a balance-unbalance converter 109 having one unbalanced terminal 105 and one pair of balanced terminals 106 and 107, and which performs balance-unbalance conversion of the signal. The unbalanced terminal 104 and the unbalanced terminal 105 are connected, and filtering and balance-unbalance conversion of the signal is performed between the unbalanced terminal 101 and the balanced terminals 106 and 107. The characteristics of the FBAR filter device 108 are brought forth in the filtering of the signal. The FBAR filter device 108 and the balance-unbalance converter 109 are integrated, and provided as a single component which is compact and low-cost.

## Description

### Technical Field

The present invention relates to a filter for use in a wireless device such as a mobile phone.

### Background Art

In a wireless device such as a mobile phone, filtering at the antenna end and between stages is necessary in order to prevent unwanted emission of transmission waves, deterioration of sensitivity due to diffraction of transmission waves to a receiving unit, image rejection at the receiving unit, and the like. Conventionally, surface acoustic wave (SAW), inter-stage filtering using dielectric material, and shared devices have been used. In particular, film bulk acoustic resonator (FBAR) filters are being used in systems in which transmission and reception frequency intervals are narrow, and steeper filter characteristics are required.

Furthermore, in order to respond to cases where the input and output of circuit blocks located before and after a filter are different in terms of being differential or single-ended, it is preferable for a filter to have a balance-unbalance conversion function, and SAW filters having the balance-unbalance conversion function are already being put to practical use.

Here, the film bulk acoustic resonator which is the main part of an FBAR filter is made up of a piezoelectric film sandwiched between electrodes. The FBAR filter performs filtering using the resonance vibration (referred to as bulk elastic wave) of such piezoelectric film. Such a structure is suitable for the preparation of the FBAR filter as a chip by forming the FBAR filter on a substrate such as a semiconductor substrate, a dielectric substrate, and a metal substrate, using a semiconductor process.

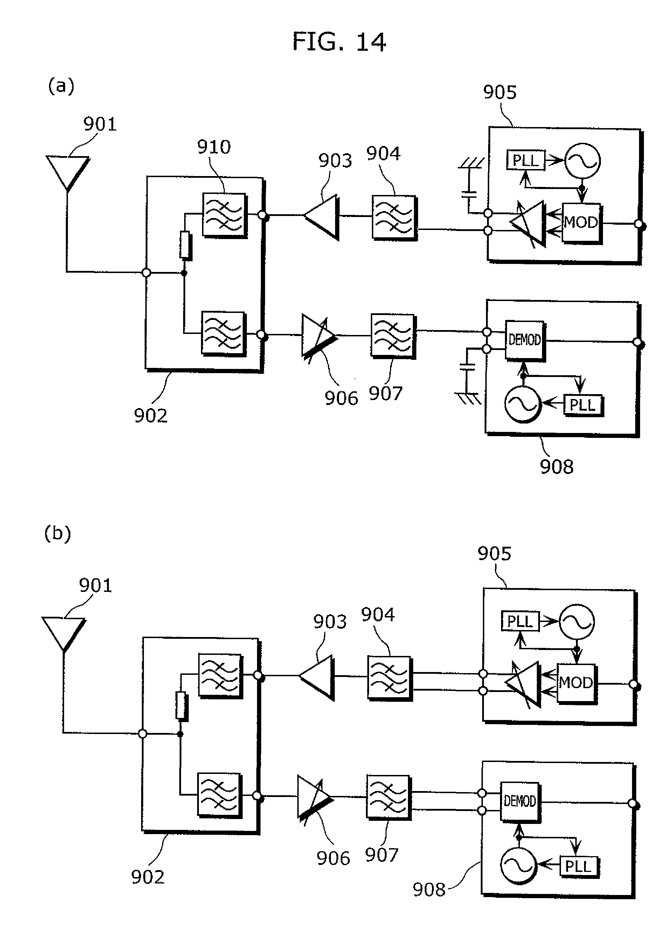

Hereinafter, common conventional examples shall be described using FIG. 14(a) and FIG. 14(b). These conventional examples are disclosed, for example, in patent reference number 1.

FIG. 14(a) is a diagram showing an example of the configuration of a wireless circuit of a wireless device such as a mobile phone, in the case of using a filter without a balance-unbalance conversion function. The wireless circuit includes an antenna 901, a shared device 902, a PA (power amplifier) 903 as a transmission unit, a transmission inter-stage BPF (hereafter referred to as TxBPF) 904, a modulation IC 905, an LNA (Low Noise Amplifier: AGC function-equipped) 906, a reception inter-stage BPF (hereafter referred to as RxBPF) 907 as a receiving unit, and a demodulation IC 908.

. A signal for transmission is lead from the modulation IC 905 to the antenna 901, via the TxBPF 904, the PA 903, and the shared device 902. On the other hand, a received signal is lead from the antenna 901 to the demodulation IC 908, via the shared device 902, the LNA 906, and the RxBPF 907.

Generally, in order to strengthen against outside noise, semiconductors such as a modulation IC and demodulation IC often adopt a differential configuration for internal circuits, and input and output terminals have balanced input and output.

FIG. 14(b) is a diagram showing an example of the configuration of a wireless circuit of a wireless device such as a mobile phone, in the case where a filter having a balance-unbalance conversion function is used. The structural outline and signal flow are the same as in FIG. 14(a).

TxBPF 954 and RxBPF 957 are respective filters having the balance-unbalance conversion function, and are equivalent to conventional SAW filters. In this case, in the transmission unit, the TxBPF 954 and the modulation IC 905 can be directly connected, and a signal differentially outputted from the modulation IC 905 is balance-unbalance converted by the TxBPF 954 and lead to the PA 903. Likewise, in the receiving unit, the RxBPF 957 and the demodulation IC 908 can be directly connected, and a unbalanced signal inputted to the RxBPF 957 from the shared device 902 via the LNA 906 is unbalance-balance converted by the RxBPF 957 to become a balanced signal which is then inputted to the demodulation IC 908.

Compared to the SAW filter, the FBAR filter possesses outstanding characteristics in terms of loss, attenuation, and temperature properties and the like. However, since it does not have a balance-unbalance conversion function, the connection with other circuit blocks is as in FIG. 14(a).

In the transmission unit, one signal differentially outputted from the modulation IC 905 is lead to a ground, and the other is inputted to the TxBPF 904. Furthermore, in the receiving unit, one of the differential inputs of the demodulation IC 908 flows to a ground, and the unbalanced signal outputted from the RxBPF 907 is inputted to the other.
Patent Reference 1: Japanese Laid-Open Patent No. 2001-28552

### Disclosure of Invention

### Problems that Invention is to Solve

However, as described above, there are no conventional FBAR filters having the balance-unbalance conversion function. Therefore, in the case where the FBAR filter is used in a system requiring steeper filter characteristics than in the SAW filter, an arrangement such as simply connecting one of the balanced input and output terminals of another circuit block to the FBAR filter and grounding the other.

With regard to the specific example shown in FIG. 14(A), in the transmission unit, a signals differentially outputted from the modulation IC 905 flows to a ground on one side, and inputted to the TxBPF 904 on the other. Furthermore, in the receiving unit, one of the differential inputs of demodulation unit 908 is grounded and the other receives the unbalanced signal outputted from the TxBPF 907. In such a case, during input and output, about half of the signal is lost and, due to worsening power efficiency and noise factor, there is the problem that the outstanding characteristics of the FBAR filter are negated.

The present invention is conceived in view of the aforementioned problem and has as an object to provide an FBAR filter added with a balance-unbalance conversion function.

### Means to Solve the Problems

In order to solve the aforementioned problem, the film bulk acoustic resonator filter in the present invention is a film bulk acoustic resonator filter including: a film bulk acoustic resonator filter device which filters a signal; and a balance-unbalance converter which performs balance-unbalance conversion on a signal, wherein the film bulk acoustic resonator filter device and the balance-unbalance converter are connected electrically and integrated.

Here, it is also possible that the film bulk acoustic resonator filter device includes two first unbalanced terminals or two pairs of first balanced terminals, and performs the filtering on the signal between the two first unbalanced terminals or the two pairs of first balanced terminals, the balance-unbalance converter includes one second unbalanced terminal and one pair of second balanced terminals, and performs the balance-unbalance conversion on the signal between the one second unbalanced terminal and the one pair of second balanced terminals, in the case where the film bulk acoustic resonator filter device includes two first unbalanced terminals, one of the first unbalanced terminals is connected to the second unbalanced terminal, and the film bulk acoustic resonator filter device performs the filtering and the balance-unbalance conversion on the signal between the other of the first unbalanced terminals and the one pair of second balanced terminals, and in the case where the film bulk acoustic resonator filter device includes two pairs of first balanced terminals, one pair of the first balanced terminals and the one pair of second balanced terminals are connected, and the film bulk acoustic resonator filter device performs the filtering and the balance-unbalance conversion on the signal between the other pair of the first balanced terminals and the second unbalanced terminal.

According to this configuration, a film bulk acoustic resonator filter having the combination of the characteristics of the film bulk acoustic resonator filter device and the balance-unbalance conversion function can be realized. It allows the film bulk acoustic resonator filter device and the balance-unbalance converter to be integrated, and thus allowing such film bulk acoustic resonator filter to be provided as a single component which is compact and low-cost.

In addition, either one of an unbalanced input and output type and a balanced input and output type can be used in the film bulk acoustic resonator filter device.

Furthermore, it is also possible that the balance-unbalance converter is formed on the surface or inside a substrate, and the film bulk acoustic resonator filter device is mounted on the substrate.

Here, it is also possible to configure the balance-unbalance converter using one or more among a balun, a rat race circuit, a Wilkinson circuit, and a phase rotation circuit.

According to this configuration, the balance-unbalance converter can be implemented as a passive device and, by connecting one side of the film bulk acoustic resonator filter device to such passive device, in-band and out-of-band frequency characteristics can be stabilized.

Furthermore, the circuit function of any of the balun, the rat race circuit, the Wilkinson circuit, and the phase rotation circuit can be built into an internal layer of a substrate using striplines formed using the appropriate pattern. By building in such circuits inside the mounting substrate on which the film bulk acoustic resonator filter device is mounted, it is possible to suppress the enlargement in floor size and increase in cost for the addition of a balance-unbalance conversion function.

Furthermore, it is also possible to have one or more among the rat race circuit, the Wilkinson circuit, and the phase rotation circuit configured using phase rotation circuits configured in a T-shape or a π-shape, using inductors and condensers.

According to this configuration, the options for the method of implementing the film bulk acoustic resonator filter are increased as, aside from the pattern of the internal layer of the mounting substrate, configuration also becomes possible using a condenser (MIM capacitor, IDT, FBAR capacitance device, MEMS, and so on) or inductor (spiral inductor, wire inductance element, FBAR inductance element, MEMS, and so on) on a semiconductor substrate, by replacing the striplines with lump-constant inductors or capacitors. For example, the balance-unbalance conversion function can be built into the FBAR filter chip itself, using, for example, a semiconductor process.

Furthermore, it is also possible that the balance-unbalance converter is made up of a single-stage amplification circuit having one input terminal and two output terminals, and which outputs, in an opposite phase, a signal obtained from the input terminal, to the output terminals, the input terminal corresponds to the second unbalanced terminal, and the two output terminals correspond to the one pair of second balanced terminals.

According to this configuration, it is suitable to have the balance-unbalance conversion function built into the FBAR filter chip itself, using, for example, a semiconductor process.

Furthermore, it is also possible that the film bulk acoustic resonator filter device is formed as a first chip, and the balance-unbalance converter is formed as a second chip, and is a surface acoustic wave filter having a signal balance-unbalance conversion function.

According to this configuration, since both the film bulk acoustic resonator filter device and the balance-unbalance converter is formed on a chip, the film bulk acoustic resonator filter provides an advantage in terms of compact and low-cost mounting.

In particular, by performing filtering mainly in the film bulk acoustic resonator filter device and performing balance-unbalance conversion in the surface acoustic wave filter, loss is minimal and the FBAR filter having a balance-unbalance conversion function can be realized.

Furthermore, it is also possible that one of the first chip and the second chip is flip-chip mounted on the other.

According to this configuration, by carrying out flip-chip mounting, it is possible to significantly further the miniaturization and cost-reduction of the film bulk acoustic resonator filter and, at the same time, the impedance at the connections can be arbitrarily set. Therefore, together with the improvement in design flexibility, unnecessary impedance can be reduced as much as possible.

Furthermore, it is also possible that the film bulk acoustic resonator filter device and the surface acoustic wave filter are formed on one substrate.

According to this configuration, the film bulk acoustic resonator filter device and surface acoustic wave filter can be consecutively formed on the single substrate, using a semiconductor process, and thus contribute to cost reduction.

Furthermore, it is also possible that a piezoelectric thin film constituting the film bulk acoustic resonator filter device is placed by transferring a multi-layer film formed on a substrate which is different from the one substrate.

According to this configuration, since a film bulk acoustic resonator filter device can be configured using piezoelectric film having a satisfactory membrane formed on such different substrate, an FBAR filter with satisfactory characteristics can easily be obtained.

### Effects of the Invention

According to the present invention, since the film bulk acoustic resonator filter is configured by electrically connecting and integrating the film bulk acoustic resonator filter device which performs filtering and the balance-unbalance converter which performs balance-unbalance conversion, a film bulk acoustic resonator filter having the combination of the primary characteristics of the film bulk acoustic resonator filter device and the balance-unbalance conversion function can be obtained. The present invention makes it possible to integrate the film bulk acoustic resonator filter device and the balance-unbalance converter, and provide a film bulk acoustic resonator filter as a single component which is compact and low-cost.

### Brief Description of Drawings

FIG. 1 is a block diagram showing an example of the configuration of the FBAR filter in the first embodiment.
FIG. 2(a), (b), (c) and (d) are a top view, bottom view, and cross-sections showing an example of the configuration of the FBAR filter in the second embodiment.
FIG. 3 is a diagram showing an example of the internal layers forming the balun in the second embodiment.
FIG. 4 is a block diagram showing an example of the configuration of the FBAR filter in the third embodiment.
FIG. 5 is a block diagram showing an example of the configuration of the FBAR filter in a variation of the third embodiment.
FIG. 6 is a block diagram showing an example of the configuration of the FBAR filter in the fourth embodiment.
FIG. 7 is a block diagram showing an example of the configuration of the FBAR filter in a variation of the fourth embodiment.
FIG. 8 is a block diagram showing an example of the configuration of the FBAR filter in the fifth embodiment.
FIG. 9(a) and (b) are block diagrams showing an example of the configuration of the FBAR filter in the sixth embodiment.
FIG. 10(a), (b) and (c) are a top view and crosss-sections showing an example of the configuration of the FBAR filter in the seventh embodiment.
FIG. 11(a), (b), (c) and (d) are top views and crosss-sections showing an example of the configuration of the FBAR filter in the eighth embodiment.
FIG. 12(a) and (b) are a top view and a crosss-section showing an example of the configuration of the FBAR filter in the ninth embodiment.
FIG. 13(a), (b), (c) and (d) are diagrams showing a manufacturing method of the FBAR filter in the tenth embodiment.
FIG. 14(a) and (b) are block diagrams showing an example of the configuration of a wireless circuit using the conventional filter.

### Numerical References

- 101: Input terminal
- 102, 103: Output terminal (one side of differential terminals)
- 104: Output terminal of FBAR filter chip
- 105: Input terminal of balun
- 106, 107: Output terminal of balun (one side of differential terminals)
- 108: FBAR filter chip
- 109: Balun
- 111, 112 λ/4: 110 λ/2 stripline
- 201, 211: Cap
- 202, 212: Multi-layer substrate
- 204, 214: FBAR filter chip
- 205, 215: Wire bonding
- 206, 216: Internal layer pattern
- 207, 217: Pad of multi-layer substrate
- 209, 219: Pad of FBAR filter chip
- 301, 304: GND layer
- 302 λ/2: stripline layer
- 303 λ/4: stripline layer
- 305: Input terminal of balun
- 306: λ/2 stripline
- 307: Ground of λ/4 stripline
- 308: Differential output terminal of balun
- 307 λ/4: stripline
- 401, 501, 601, 605, 701, 801: Input terminal
- 402, 403, 502, 503, 602, 603, 606, 607, 702, 703, 802, 803: Output terminal
- 404, 504, 611, 704, 804: FBAR filter
- 405, 505: Rat race circuit
- 406, 407, 408, 409: Port
- 506, 708: HPF
- 608, 609, 610: Connection point
- 612, 705: Wilkinson circuit
- 618: Phase inverter circuit
- 706: Phase rotation circuit
- 805: Single-stage amplifier
- 806: FET
- 807: Gate load
- 808: Drain load
- 809: Source load
- 810: Power source
- 811: Ground
- 1101, 1111, 1211, 1213, 1304, 1306, 1404, 1406: Input terminal
- 1102, 1103, 1112, 1113, 1212, 1214, 1215, 1305, 1307, 1308, 1309, 1310, 1405, 1407, 1408: Output terminal
- 1104, 1114, 1115: Connection point
- 1105, 1117: FBAR filter
- 1106, 1116: SAW filter
- 1201: Mounting substrate
- 1202, 1301: FBAR filter chip
- 1203, 1302: SAW filter chip
- 1311: Flip-chip
- 1401, 1501: Piezoelectric substrate
- 1402: FBAR filter
- 1502: Dummy substrate
- 1503: SAW filter
- 1504: Piezoelectric film

### Best Mode for Carrying Out the Invention

### (First Embodiment)

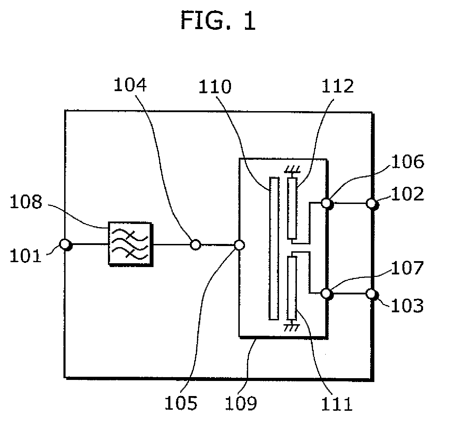

The FBAR filter according to the first embodiment of the present invention shall be described with reference to FIG. 1. FIG. 1 is a block diagram showing an example of the configuration of the FBAR filter according to the first embodiment of the present invention. The FBAR filter includes an FBAR filter 108 and a balun 109 which are formed on a chip. Here, the balun 109 is used as a balance-unbalance converter.

The FBAR filter 108 has unbalanced input and output terminals 101 and 104. The balun 109 includes an open-end λ/2 stripline 110 and two shorted-end λ/4 striplines 111 and 112, and has one input terminal 105 and two output terminals 106 and 107. The unbalanced signal inputted from the input terminal 105 is converted into a balanced signal through the combination of the λ/2 stripline 110 and the λ/4 striplines 111 and 112, and outputted from the two output terminals 106 and 107. With this configuration, an FBAR filter having the balance-unbalance conversion function is realized. In addition, by connecting one of the input and output terminals to a passive device, the in-band and out-of-band frequency characteristics of the FBAR filter can be stabilized. Note that for this filter, input and output are reversible.

Furthermore, as shown in FIG. 1, this FBAR filter includes output terminals 102 and 103.

### (Second Embodiment)

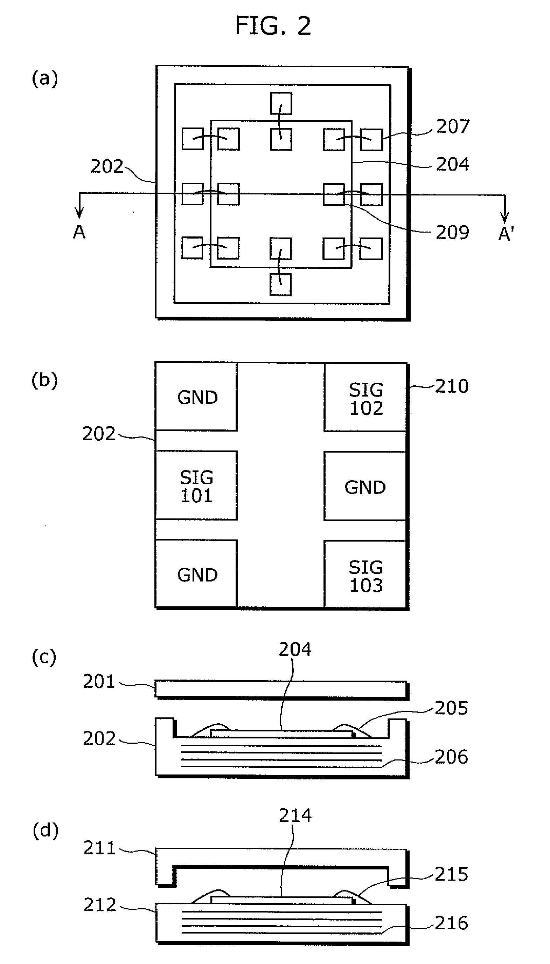

The FBAR filter according to the second embodiment of the present invention shall be described with reference to FIG. 2. The FBAR filter in this embodiment takes advantage of the previously discussed characteristic of easy formation on a substrate using a semiconductor process. An FBAR filter device prepared as chip is mounted, for example, on a multi-layer substrate and, in addition, sealed in a ceramic package and the like, in order to maintain reliability. Naturally, aside from the ceramic package, sealing with a stainless cap, and the like, is also possible.

FIG. 2(a) is a top view of the FBAR filter as seen from the cap side (cap is not illustrated). FIG. 2(b) is a bottom view of the FBAR filter. FIG. 2(c) is a A to A' cross-section of the FBAR filter, and FIG. 2(d) is a cross-section of a variation of the FBAR filter.

As seen in FIG. 2(c) and (d), the space for storing the FBAR filter chip is created by providing projections on a multi-layer substrate 202 (FIG. 2(c)) or providing the projections on a cap 211 (FIG. 2(d)).

An example of the configuration of the FBAR filter shall be described using FIG. 2(a), (b) and (c). An FBAR filter chip 204 is mounted on the multi-layer substrate 202. An internal layer pattern 206 making up a balun is formed in internal layers of the multi-layer substrate 202. The configuration of the balun shall be described in detail later.

A pad 207 is formed on the multi-layer substrate 202. Conduction is achieved between the pad 207 of the multi-layer substrate and a pad 209 of the FBAR filter chip using wire bonding 205. Then, the cap 201 is mounted on top of the multi-layer substrate 202.

On the bottom surface of the multi-layer substrate 202, a plurality of terminals 210 is provided. For example, the terminal indicated as SIG 101 is connected, inside the multi-layer substrate 202, with one of the terminals of the FBAR filter chip 204. Terminals indicated as SIG 102 and SIG 103 are connected, inside the multi-layer substrate 202, with the balanced input and output terminals of the balun, and the terminals indicated as GND are connected to the ground of the entire FBAR filter.

Next, another example of a configuration of the FBAR filter shall be described using FIG. 2(d). An FBAR filter chip 214 is mounted on a multi-layer substrate 212. An internal layer pattern 216 making up a balun is formed in internal layers of the multi-layer substrate 212. Moreover, in the multi-layer substrate 212, a pad 217 of the multi-layer substrate is formed. Conduction is achieved between the pad 217 of the multi-layer substrate and a pad 219 of the FBAR filter chip using wire bonding 215. A cap 211 is mounted on top of the multi-layer substrate 202.

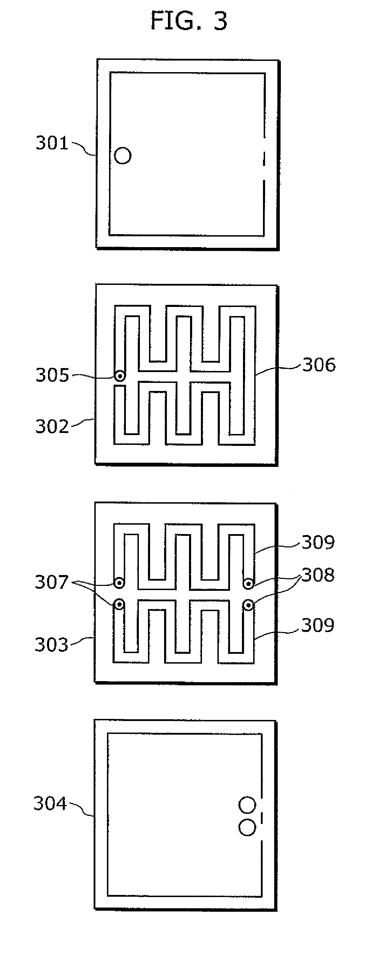

Hereinafter, the balun configured in the internal layers of the multi-layer substrate 202 shall be described using FIG. 3. FIG. 3 shows, on a per-layer basis, an example of the pattern of each layer making up the balun. A λ/2 stripline 306 and two λ/4 striplines 309 are formed in pattern layers 302 and 303 which are sandwiched by ground layers 301 and 304.

The unbalanced signal inputted from the input terminal 305 is lead to the two λ/4 striplines having ends that are shorted to a ground using grounded thru-holes 307, and outputted from two output terminals 308 through the coupling in the open-end λ/2 stripline 306 and the shorted-end λ/4 striplines 309.

In the FBAR filter according to the present embodiment, an FBAR filter added with the balance-unbalance conversion function can be provided without an enlargement in size and a significant increase in cost as compared to when a balun is not provided, by having the balun built-in inside the multi-layer substrate 212 for mounting the FBAR filter chip. Note that for this filter, input and output are reversible.

### (Third Embodiment)

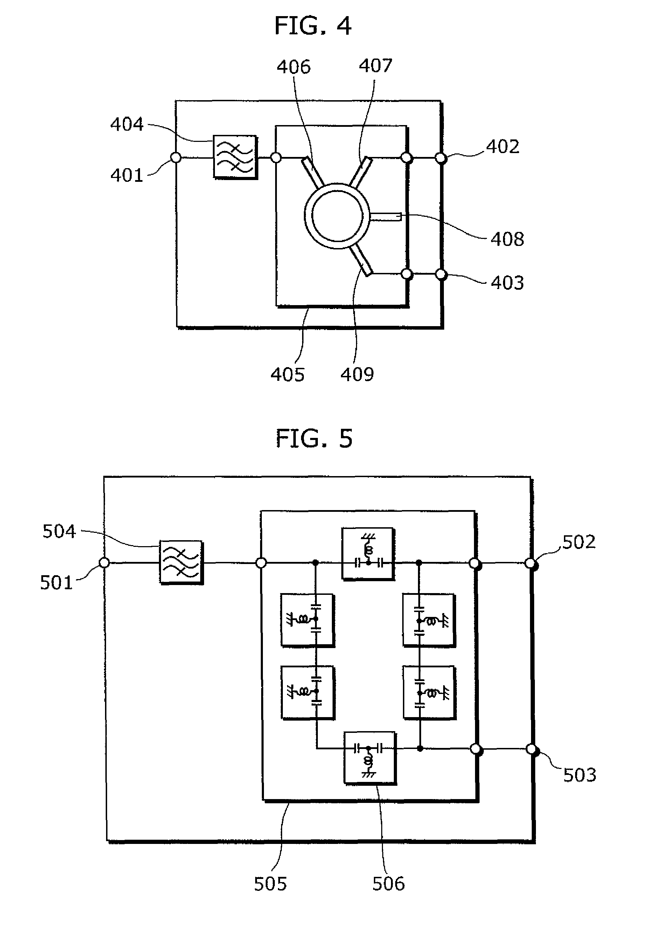

Next, the FBAR filter according to the third embodiment of the present invention shall be described with reference to FIG. 4. FIG. 4 is a block diagram showing an example of the configuration of the FBAR filter according to the third embodiment of the present invention. The FBAR filter includes a rat race circuit 405 as a balance-unbalance converter.

An FBAR filter chip 404 has unbalanced input and output terminals. In the rat race circuit 405, as shown in FIG. 4, ports are positioned so that there is a λ/4 separation between port 406 and port 407, port 407 and port 408, port 408 and port 409, and a 3λ/4 separation between port 406 and port 409. A signal is inputted from the port 406. In port 407, the signal, which has advanced clockwise for λ/4 of the ring from port 406, and the signal, which has advanced counter-clockwise for 3λ/4 of the ring from port 406, are attained. These two signals, which are in-phase, are added together, and outputted from the port 407. Port 409 is in a 3λ/4 position both clockwise and counterclockwise with respect to port 406, and thus the signals are added together and outputted. In port 408, the signal, which has advanced clockwise for λ/2 from port 406, and the signal, which has advanced counter-clockwise for λ from port 406, are attained. These two signals have opposite phases and cancel out, and thus no signal is outputted. At this time, the outputs of port 407 and 409 have opposite phases.

In other words, the unbalanced signal inputted from the input terminal is converted into a balanced signal by the rat race circuit 405. According to this configuration, by adding a balance-unbalance conversion function to the FBAR filter and, in addition, by connecting one of the input and output terminals to a passive device, the in-band and out-of-band frequency characteristics of the FBAR filter can be stabilized. Note that for this filter, input and output are reversible. Moreover, as shown in FIG. 4, the FBAR filter includes an input terminal 401 and output terminals 402 and 403.

By having the rat race circuit built into the internal layers of the multi-layer substrate for mounting the FBAR filter chip, it is possible to provide an FBAR filter added with the balance-unbalance conversion function without an enlargement in size and a significant increase in cost as compared to when the rat race circuit is not provided.

### (Variation)

In addition, by configuring the striplines shown in FIG. 4 with T-shape and π-shape LPFs (Low Pass Filter) and HPFs (High Pass Filter) as in FIG. 5, it is possible to configure a rat race circuit 505 in the same manner. FIG. 5 shows an example of such a circuit configured using CLC T-shape HPF 506, together with an FBAR filter 504. In this circuit example, the striplines shown in FIG. 4 are replaced with lumped-constant inverters (L) or capacitors (C). With this, configuration in the internal layers of the mounting substrate, and configuration using capacitors (MIM capacitor, IDT, FBAR capacitance device, MEMS, and so on) and inductors (spiral inductor, wire inductance element, FBAR inductance element, MEMS, and so on) on a semiconductor substrate inside the same chip as the FBAR filter in the filter chip becomes possible, and the options for the configuration method of the present invention is increased. Furthermore, it also becomes possible to have the balance-unbalance conversion function built into the FBAR filter chip itself using, for example, a semiconductor process.

Note that, as shown in FIG. 5, the FBAR filter includes an input terminal 501 and output terminals 502 and 503.

### (Fourth Embodiment)

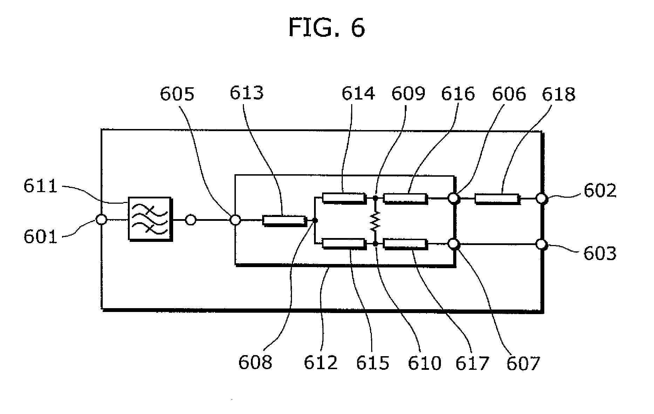

Next, the FBAR filter according to the fourth embodiment of the present invention shall be described with reference to FIG. 6. FIG. 6 is a block diagram showing an example of the configuration of the FBAR filter according to the fourth embodiment of the present invention. The FBAR filter includes a Wilkinson circuit 612 and a phase inverter circuit 618, as a balance-unbalance converter.

An FBAR filter chip 611 has unbalanced input and output terminals. As shown in FIG. 6, the Wilkinson circuit 612 has one input terminal 605 and two output terminals 606 and 607. A signal is inputted from the input terminal 605, and separated in-phase signals are extracted from the output terminals 606 and 607. In this case, the size of the signals outputted from the output terminals 606 and 607 are on a one-to-one proportion.

As shown in FIG. 6, in the configuration of the Wilkinson circuit 612, a stripline 613 is inserted between the input terminal 605 and a connection point 608; striplines 614 and 615 are inserted between the connection point 608 and a connection point 609, and between the connection point 608 and a connection point 610 respectively; a 100Ω resistor is inserted between the connection point 609 and the connection point 610; and striplines 616 and 617 are inserted between the connection point 609 and the output terminal 606, and between the connection point 610 and the output terminal 607 respectively.

Through the optimal selection of the impedance and amount of phase rotation for the aforementioned stripline, it becomes possible to have a signal inputted from the input terminal 605, and extract separated in-phase signals from the output terminals 606 and 607.

The phase inverter circuit 618 is made up of a stripline, and rotates the phase 180 degrees by optimally selecting the impedance and length.

The unbalanced signal inputted from an input terminal 601 of the FBAR filter is filtered in the FBAR filter chip 611; converted into in-phase signals by the Wilkinson circuit 612; converted into balanced signals by the phase inverter circuit 618 through the 180 degree phase-rotating of one of the in-phase signals; and outputted from the output terminals 602 and 603 of the FBAR filter.

According to this configuration, by adding a balance-unbalance conversion function to the FBAR filter and, in addition, by connecting one of the input and output terminals to a passive device, the in-band and out-of-band frequency characteristics of the FBAR filter can be stabilized. Note that for this filter, input and output are reversible.

By having such a Wilkinson circuit 612 and phase rotation circuit 618 built into the internal layers of the multi-layer substrate for mounting the FBAR filter chip, it is possible to provide an FBAR filter having the balance-unbalance conversion function without an enlargement in size and a significant increase in cost as compared to when such circuits are not provided.

### (Variation)

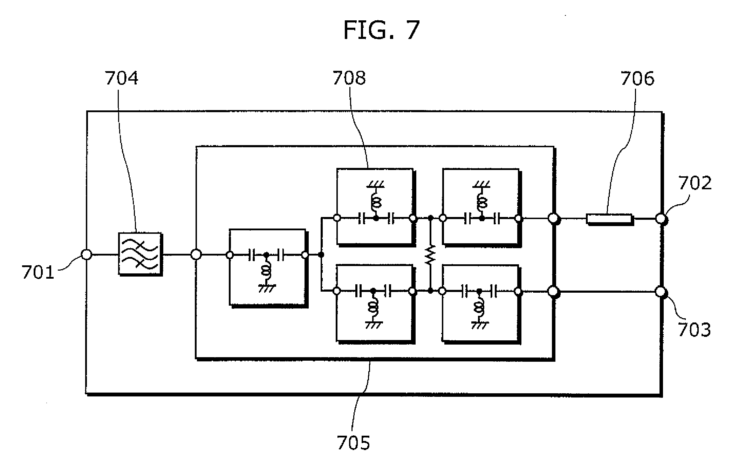

In addition, as shown in FIG. 7, by configuring the striplines in FIG. 6 with T-shape and π-shape LPFs (Low Pass Filters) and HPFs (High Pass Filters) as in FIG. 5, it is possible to configure a Wilkinson circuit 705 and a phase rotation circuit 706 in the same manner. FIG. 7 shows an example of such a circuit configured using CLC T-shape HPFs 708, together with an FABR filter 704. In this circuit example, the striplines shown in FIG. 6 are replaced with lumped-constant inductors (L) or capacitors (C). With this, configuration in the internal layers of the mounting substrate, and configuration using capacitors (MIM capacitor, IDT, FBAR capacitance device, MEMS, and so on) and inductors (spiral inductor, wire inductance element, FBAR inductance element, MEMS, and so on) on a semiconductor substrate inside the same chip as the FBAR filter in the filter chip becomes possible, and the options for the configuration method of the present invention is increased. Furthermore, it also becomes possible to have the balance-unbalance conversion function built into in the FBAR filter chip itself, using a semiconductor process for example.

Note that, as shown in FIG. 7, the FBAR filter includes an input terminal 701 and output terminals 702 and 703.

### (Fifth Embodiment)

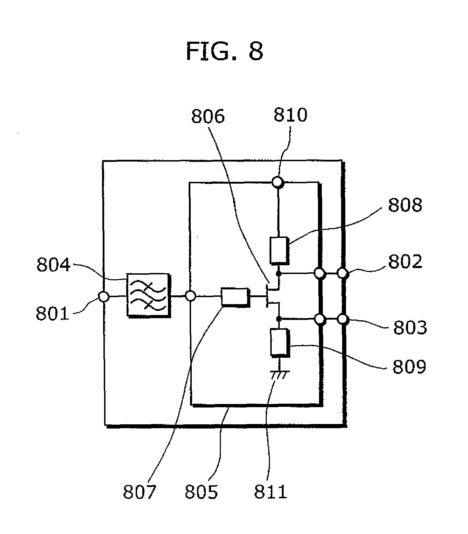

Next, the FBAR filter according to the fifth embodiment of the present invention shall be described with reference to FIG. 8. FIG. 8 is a block diagram showing an example of the configuration of the FBAR filter according to the fifth embodiment of the present invention. The FBAR filter includes a single-stage amplifier 805 as a balance-unbalance converter.

An FBAR filter 804 has unbalanced input and output units. The single-stage amplifier (bias circuit not illustrated) 805 includes an FET 806 and a gate load 807. In addition, a drain load 808 is connected between the drain of the FET 806 and a power source 810, and a source load 809 is connected between the source and a ground 811. Power is applied and a signal is inputted from the gate and a signal is extracted from the drain and the source. By appropriately selecting the source load 809 and the drain load 808, opposite-phased signals can be extracted at the same signal level.

In other words, the unbalanced signal inputted from an input terminal 801 is converted into a balanced signal using the single-stage amplifier 805, and outputted from output terminals 802 and 803. With this configuration, an FBAR filter having an unbalanced-balanced conversion function is realized.

### (Sixth Embodiment)

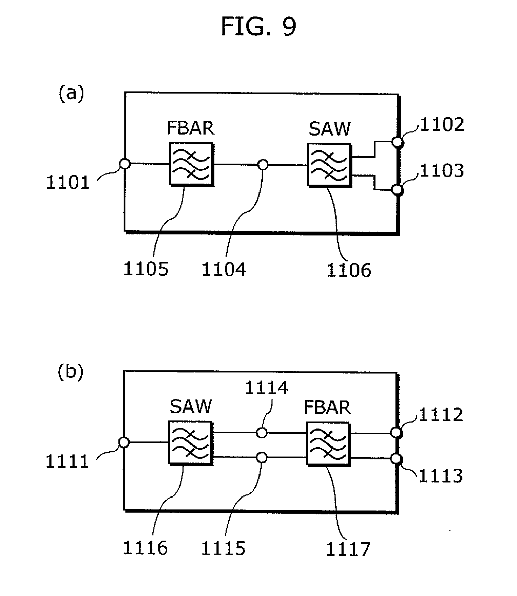

The FBAR filter according to the sixth embodiment of the present invention shall be described with reference to FIG. 9(a) and (b).

FIG. 9(a) is a block diagram showing an example of the configuration of the FBAR filter according to the sixth embodiment of the present invention. Such FBAR filter is made up of an FBAR filter chip 1105 formed on a chip and a SAW filter chip 1106 formed on the chip. Here the SAW filter chip 1106 is used as a balance-unbalance converter.

The FBAR filter chip 1105 includes unbalanced input and output terminals 1101 and 1104. The SAW filter chip 1106 has a balance-unbalance conversion function and includes one input terminal 1104 and two output terminals 1102 and 1103. The unbalanced signal inputted from the input terminal 1104 is converted into a balanced signal, and outputted from the two output terminals 1102 and 1103. By connecting the output terminal of the FBAR filter 1105 and the input terminal of the SAW filter 1106, a FBAR filter having a balance-unbalance conversion function can be realized. In this configuration, by performing filtering mainly in the FBAR filter 1105 and performing balance-unbalance conversion mainly in the SAW filter 1106, loss is minimal and an FBAR filter having a balance-unbalance conversion function can be realized. Note that for this filter, input and output are reversible.

FIG. 9(b) is a block diagram showing another example of the configuration of the FBAR filter according to the sixth embodiment of the present invention. Such FBAR filter is made up of a SAW filter chip 1116 formed on a chip and an FBAR filter chip 1117 formed on the chip. Here the SAW filter chip 1116 is used as a balance-unbalance converter.

The SAW filter chip 1106 has a balance-unbalance conversion function and includes one input terminal 1111 and two output terminals 1114 and 1115. The unbalanced signal inputted from the input terminal 1111 is converted into a balanced signal and outputted from the two output terminals 1114 and 1115. The FBAR filter chip 1117 includes unbalanced input and output terminals 1114 and 1115 on one side, and unbalanced input and output terminals 1112 and 1113 on the other side. By connecting the output terminal of the SAW filter chip 1116 and the input and output terminals on one side of the FBAR filter chip 1117, the FBAR filter having a balance-unbalance conversion function can be realized.

### (Seventh Embodiment)

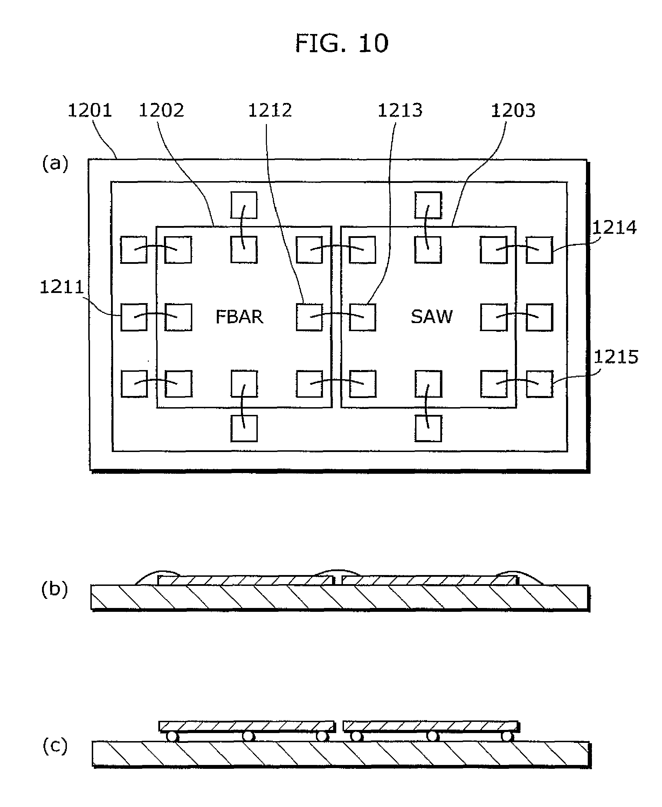

The FBAR filter according to the seventh embodiment of the present invention shall be described with reference to FIG. 10.

FIG. 10(a) is a top view of the FBAR filter, FIG. 10(b) is a cross-section of the FBAR filter, and FIG. 10(c) is a cross-section of a variation of the FBAR filter.

The FBAR filter includes a mounting substrate 1201, an FBAR filter chip 1202, and a SAW filter chip 1203. The FBAR filter chip 1202 includes unbalanced input and output terminals 1211 and 1212. The SAW filter chip 1203 has a balance-unbalance conversion function and includes one input terminal 1213 and two output terminals 1214 and 1215. The unbalanced signal inputted from the input terminal 1213 is converted into a balanced signal and outputted from the two output terminals 1214 and 1215.

By connecting the output terminal of the FBAR filter chip 1202 and the input terminal of the SAW filter chip 1203, an FBAR filter added with the balance-unbalance conversion function can be realized. In this configuration, by performing filtering mainly in the FBAR filter 1202 and performing balance-unbalance conversion mainly in the SAW filter 1203, loss is minimal and the FBAR filter having a balance-unbalance conversion function can be realized. Note that for this filter, input and output are reversible. In addition, by connecting the FBAR filter and the SAW filter in a short connection using only wire bonding, unnecessary inductance can be minimized.

Furthermore, as shown in FIG. 10(c), by flip-chip mounting the FBAR chip and SAW chip on the mounting substrate, it is possible to arbitrarily set the impedance at the connection, and improve design flexibility.

### (Eighth Embodiment)

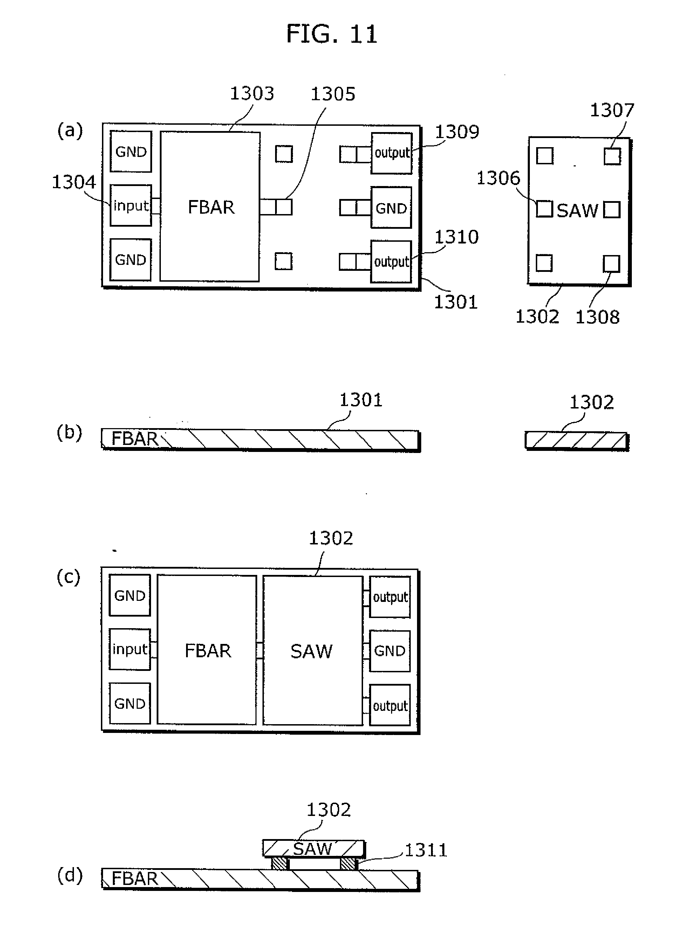

The FBAR filter according to the eighth embodiment of the present invention shall be described with reference to FIG. 11.

FIG. 11(a) and (b) is a top view and a cross-section of the FBAR filter before SAW chip mounting, and FIG. 11(c) and (d) is a top view and a cross-section of the FBAR filter after SAW chip mounting.

The FBAR filter is made up of an FBAR filter chip 1301 and a SAW filter chip 1302. In the FBAR filter chip 1301, an FBAR filter device (referred to as an FBAR filter device to distinguish from the entire FBAR filter) 1303 is formed, for example, using a semiconductor process, and the SAW filter chip 1302 is flip-chip mounted on the surface of the FBAR filter chip 1301.

The FBAR filter chip 1303 includes unbalanced input and output terminals 1304 and 1305. The SAW filter chip 1302 has a balance-unbalance conversion function and includes one input terminal 1306 and two output terminals 1307 and 1308. The unbalanced signal inputted from the input terminal 1306 is converted into a balanced signal and outputted from the two output terminals 1307 and 1308. By mounting the SAW filter chip 1302 on the FBAR filter chip 1301 by the flip-chip mounting, and connecting the output terminal of the FBAR filter and the input terminal of the SAW filter, an FBAR filter added with a balance-unbalance conversion function can be realized. In this configuration, by performing filtering mainly in the FBAR filter 1301 and performing balance-unbalance conversion mainly in the SAW filter 1302, loss is minimal and the FBAR filter having a balance-unbalance conversion function can be realized. Note that for this filter, input and output are reversible.

Note that in FIG. 11(a), output terminals 1309 and 1310 are connected to the output terminals 1307 and 1308 when the SAW filter chip 1302 is flip-chip mounted through the bump 1311.

Furthermore, by connecting the FBAR filter and the SAW filter in a short connection using only flip-chip mounting, unnecessary inductance can be minimized. In addition, by flip-chip mounting the SAW filter chip 1302 directly on top of the FBAR filter device, an even more compact filter can be provided.

### (Ninth Embodiment)

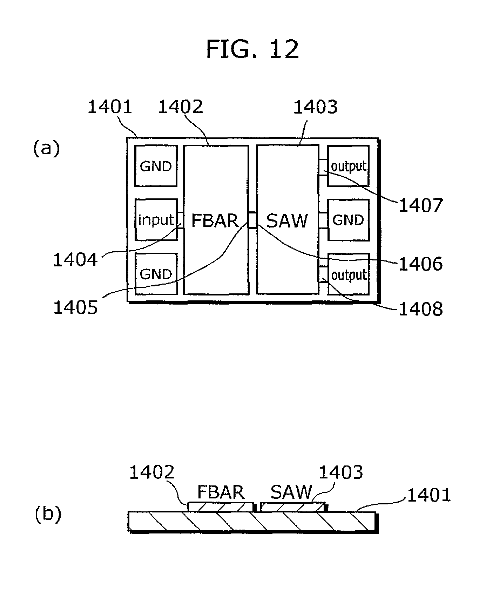

The FBAR filter according to the ninth embodiment of the present invention shall be described with reference to FIG. 12.

FIG. 12(a) and (b) is a top view and cross-section, respectively, of the FBAR filter according to the ninth embodiment of the present invention.

In the FBAR filter, an FBAR filter device 1402 and a SAW filter 1403 are formed on a shared piezoelectric substrate 1401.

The FBAR filter device 1402 includes unbalanced input and output terminals 1404 and 1405. The SAW filter 1403 has a balance-unbalance conversion function and includes one input terminal 1406 and two output terminals 1407 and 1408. The unbalanced signal inputted from the input terminal 1406 is converted into a balanced signal and outputted from the two output terminals 1407 and 1408. By connecting the output terminal 1405 of the FBAR filter device 1402 and the input terminal 406 of the SAW filter 1403, an FBAR filter added with a balance-unbalance conversion function can be realized. Furthermore, by performing filtering mainly in the FBAR filter device 1402 and performing balance-unbalance conversion mainly in the SAW filter 1403, loss is minimal and the FBAR filter having a balance-unbalance conversion function can be realized. Note that for this filter, input and output are reversible.

Furthermore, such an FBAR filter device and SAW filter can be consecutively formed on a piezoelectric substrate, using a semiconductor process, and thus contribute to cost reduction.

### (Tenth Embodiment)

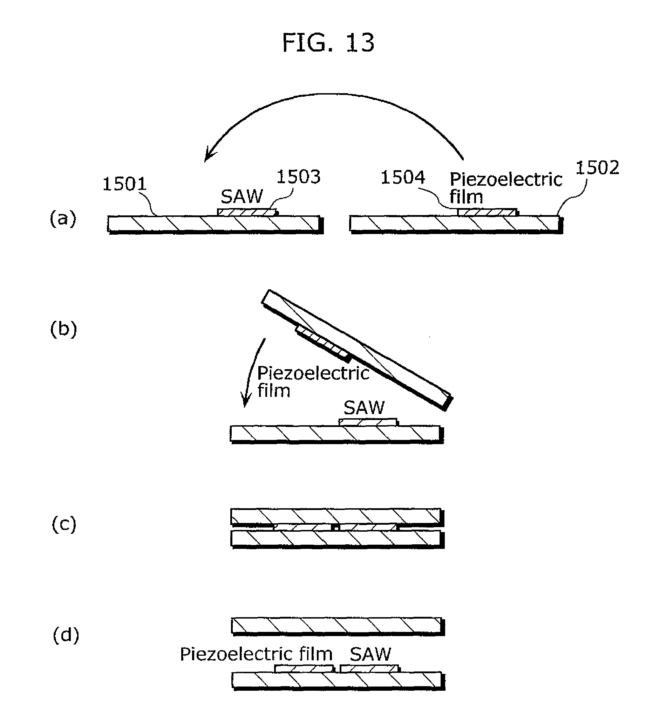

FIG. 13 is a diagram showing an example of the manufacturing method of the filter in the present invention. A piezoelectric substrate 1501 on which a SAW filter 1503 is formed, and a dummy substrate 1502 on which a piezoelectric film 1504 for the FBAR is formed, are prepared in advance, and the piezoelectric film 1504 is transferred onto the piezoelectric substrate 1501. Since the membrane, which greatly influences the characteristics of the FBAR filter, is highly dependent on the substrate at the time of piezoelectric film formation, it is difficult to form a satisfactory piezoelectric film for the FBAR filter directly on the SAW filter substrate. Thus, by preparing only the piezoelectric film on a different substrate beforehand and then transferring it, according to the aforementioned manufacturing method, an FBAR filter with excellent characteristics can be obtained.

The FBAR filter manufactured according to this manufacturing method is included in the present invention.

### Industrial Applicability

The FBAR filter in the present invention is suitably useful particularly for wireless devices such as a mobile telephone.

## Claims

1. A film bulk acoustic resonator filter comprising:
a film bulk acoustic resonator filter device which filters a signal; and
a balance-unbalance converter which performs balance-unbalance conversion on a signal,
wherein said film bulk acoustic resonator filter device and said balance-unbalance converter are connected electrically and integrated.

2. The film bulk acoustic resonator filter according to Claim 1,
wherein said film bulk acoustic resonator filter device includes two first unbalanced terminals or two pairs of first balanced terminals, and performs the filtering on the signal between the two first unbalanced terminals or the two pairs of first balanced terminals,
said balance-unbalance converter includes one second unbalanced terminal and one pair of second balanced terminals, and performs the balance-unbalance conversion on the signal between the one second unbalanced terminal and the one pair of second balanced terminals,
in the case where said film bulk acoustic resonator filter device includes two first unbalanced terminals, one of said first unbalanced terminals is connected to said second unbalanced terminal, and said film bulk acoustic resonator filter device performs the filtering and the balance-unbalance conversion on the signal between the other of said first unbalanced terminals and said one pair of second balanced terminals, and
in the case where said film bulk acoustic resonator filter device includes two pairs of first balanced terminals, one pair of said first balanced terminals and said one pair of second balanced terminals are connected, and said film bulk acoustic resonator filter device performs the filtering and the balance-unbalance conversion on the signal between the other pair of said first balanced terminals and said second unbalanced terminal.

3. The film bulk acoustic resonator filter according to Claim 1,
wherein said balance-unbalance converter is formed on the surface or inside a substrate, and
said film bulk acoustic resonator filter device is mounted on the substrate.

4. The film bulk acoustic resonator filter according to Claim 3,
wherein said balance-unbalance converter is a balun.

5. The film bulk acoustic resonator filter according to Claim 3,
wherein said balance-unbalance converter is a rat race circuit.

6. The film bulk acoustic resonator filter according to Claim 5,
wherein said rat race circuit is made up of phase rotation circuits configured in a T-shape or a π-shape using inductors and capacitors.

7. The film bulk acoustic resonator filter according to Claim 3,
wherein said balance-unbalance converter includes:
a Wilkinson circuit having one synthesis terminal and two distribution terminals; and
a phase rotation circuit which has two third unbalanced terminals, and which performs half-wavelength phase rotation on the signal between the two third unbalanced terminals,
one of said distribution terminals and one of said third unbalanced terminals are connected,
said synthesis terminal corresponds to said second unbalanced terminal, and
the other of said distribution terminals and the other of said third unbalanced terminal correspond to said one pair of second balanced terminals.

8. The film bulk acoustic resonator filter according to Claim 7,
wherein at least one of said Wilkinson circuit and said phase rotation circuit is made up of phase rotation circuits configured in a T-shape or a π-shape using inductors and capacitors.

9. The film bulk acoustic resonator filter according to Claim 1,
wherein said balance-unbalance converter is made up of a single-stage amplification circuit having one input terminal and two output terminals, and which outputs, in an opposite phase, a signal obtained from said input terminal, to said output terminals,
said input terminal corresponds to said second unbalanced terminal, and
said two output terminals correspond to said one pair of second balanced terminals.

10. The film bulk acoustic resonator filter according to Claim 1,
wherein said film bulk acoustic resonator filter device is formed as a first chip, and
said balance-unbalance converter is formed as a second chip, and is a surface acoustic wave filter having a signal balance-unbalance conversion function.

11. The film bulk acoustic resonator filter according to Claim 11,
wherein one of said first chip and said second chip is flip-chip mounted on the other.

12. The film bulk acoustic resonator filter according to Claim 1,
wherein said film bulk acoustic resonator filter device and said surface acoustic wave filter are formed on one substrate.

13. The film bulk acoustic resonator filter according to Claim 12,
wherein a piezoelectric thin film constituting said film bulk acoustic resonator filter device is placed by transferring a multi-layer film formed on a substrate which is different from the one substrate.
